# EUROPÄISCHE PATENTSCHRIFT

(11) **EP 4 140 742 B1**
(45) Veröffentlichungstag und Bekanntmachung des Hinweises auf die Patenterteilung: **11.10.2023**
(21) Anmeldenummer: 21192767.8
(22) Anmeldetag: 24.08.2021
(51) Int. Cl.: B41F 5/24, G03F 7/30, B41N 3/00

(54) **VORRICHTUNG ZUM BEFREIEN VON LÖSEMITTELHALTIGEN FLEXODRUCKPLATTEN VON DEM LÖSEMITTEL SOWIE VERFAHREN ZUM HERSTELLEN VON FLEXODRUCKPLATTEN**
DEVICE FOR RELEASING SOLVENT-BASED FLEXOGRAPHIC PRINTING PLATES FROM SOLVENT AND METHOD FOR PRODUCING FLEXOGRAPHIC PRINTING PLATES
DISPOSITIF D'ENLÈVEMENT DU SOLVANT DES PLAQUES D'IMPRESSION FLEXOGRAPHIQUE CONTENANT DU SOLVANT AINSI QUE PROCÉDÉ DE FABRICATION DE PLAQUES D'IMPRESSION FLEXOGRAPHIQUE

(43) Veröffentlichungstag der Anmeldung: 01.03.2023
(73) Patentinhaber: Weinkath, Sabine, 65623 Schiesheim (DE)
(72) Erfinder: WEINKATH, Sabine, 65623 Schiesheim (DE); MAUS, Reiner, 56357 Miehlen (DE); OTTO, Marc, 56355 Nastätten (DE)
(74) Vertreter: Richardt Patentanwälte PartG mbB

(56) Entgegenhaltungen:
- JP-A- H05 232 712
- JP-A- 2008 091 316
- US-A1- 2013 095 432

## Beschreibung

### Technisches Gebiet

Die Erfindung betrifft das Gebiet des Flexodrucks, einem Rollenrotationsdruckverfahren, bei dem flexible Druckplatten, die aus Fotopolymer oder Gummi bestehen, und niedrigviskose Druckfarben verwendet werden, so in dem Artikel aus der deutschsprachigen "Wikipedia, der freien Enzyklopädie" zum Thema "Flexodruck", erhältlich im Internet am 01. Juli 2021.

Die Erfindung befasst sich insbesondere mit dem Verfahren zum Herstellen einer beim Flexodruck verwendeten Flexodruckplatte.

### Hintergrund der Erfindung

Aus der EP 1 033 622 B1 ist ein Verfahren zur Herstellung von flexographischen Druckformen bekannt, bei dem die Infrarot-empfindliche Schicht eines fotopolymerisierbaren Aufzeichnungselements mit einer Mehrzahl von Schichten mit einem Infrarot-Laser bildmäßig strukturiert wird und so eine Maske erzeugt wird, sodann die fotopolymerisierbare Schicht des fotopolymerisierbaren Aufzeichnungselements durch eine vollflächige Belichtung durch die so hergestellte Maske bildmäßig fotopolymerisiert wird und die nicht-fotopolymerisierten Bereiche der fotopolymerisierbaren Schicht, die verbliebenen Bereiche der Infrarotempfindlichen Schicht und eine weitere Schicht durch ein oder mehrere Entwicklerlösemittel entfernt werden.

Die Erfindung geht davon aus, dass solche Entwicklerlösemittel bei der Herstellung von Flexodruckplatten verwendet werden. Solche Lösemittel müssen jedoch auch wieder entfernt werden.

Die DE 10 2010 031 527 A1 beschreibt im Zusammenhang mit der Herstellung einer einzelnen Flexodruckform, dass ein mit Lösemittel getränktes Flexodruckelement in einer Trockeneinheit getrocknet wird. Hierbei kann ein Trockengasstrom im Kreis geführt werden, wobei aus der Flexodruckplatte entwichenes Auswaschmittel in einer dazu geeigneten Vorrichtung abgetrennt wird und der abgereicherte Trockengasstrom wieder in die Trockeneinheit rückgeführt wird. Das Abtrennen des Lösemittels kann hierbei etwa durch Kondensation bei tieferen Temperaturen oder Absorption an geeigneten Absorbern erfolgen.

Aus der JP H05 232712 A ist ein Verfahren zum Herstellen von Flexodruckplatten bekannt, bei dem eine Flexodruckplatte in einer einzigen Vorrichtung mehrere Herstellungsschritte durchläuft. Beim ersten Schritt, dem Auswaschen der Flexodruckplatte mit Lösemittel, wird das Lösemittel aufgefangen und immer wieder neu zugeführt.

Aus der US 2013/095432 A1 ist es gleichermaßen bekannt, mehrere Herstellungsschritte in einer einzigen Vorrichtung durchzuführen.

Auch auf ganz anderen technischen Gebieten wie dem Gebiet der Behandlung von Vorrichtungen mit organischen Halbleitern, etwa einer organischen Solarzelle, ist etwa eine Trocknung zur Befreiung der Vorrichtung von bei deren Herstellung verwendeten spezifischem Lösemittel bekannt, wofür die JP 2008 091316 A ein Beleg ist.

Eine Vorrichtung zum Entfernen von Flüssigkeit aus einem zur Erwärmung von Gegenständen dienenden Gas ist aus der WO 2004/076948 A1 bekannt. Bei dieser Vorrichtung wird der Strom der warmen Luft regelmäßig einer Richtungsumkehr unterzogen.

### Zusammenfassung der Erfindung

Die Erfindung stellt eine Vorrichtung zum Befreien von lösemittelhaltigen Flexodruckplatten von dem Lösemittel bereit, mit einer Mehrzahl von Aufnahmen für je zumindest eine Flexodruckplatte, mit einer Heizeinrichtung zum Heizen von Luft, also zum Bereitstellen von warmer Luft, mit einer Einrichtung zum Bewegen der aufgeheizten Luft an in der Mehrzahl von Aufnahmen aufgenommenen Flexodruckplatten vorbei, sodass die aufgeheizte Luft Lösemittel von den Flexodruckplatten aufnimmt, und mit Mitteln zum Entziehen, um das Lösemittel der Luft wieder zu entziehen.

Durch eine Mehrzahl von Aufnahmen für je zumindest eine Flexodruckplatte ist die Vorrichtung einer Vorrichtung überlegen, in der jeweils nur eine einzelne Flexodruckplatte aufgenommen werden kann. Dadurch, dass die warme Luft an der Mehrzahl von Aufnahmen vorbeiströmt, kann von allen Flexodruckplatten zugleich Lösemittel durch die warme Luft aufgenommen werden. Die Heizeinrichtung kann an ganz anderer Stelle vorgesehen sein. Dadurch, dass durch die Mittel zum Entziehen das Lösemittel der Luft wieder entzogen wird, tritt das Lösemittel nicht in die Umwelt aus, und es kann geeignet entsorgt werden, gegebenenfalls sogar wiederverwendet werden.

Die Mittel zum Entziehen können gemäß einem Ausführungsbeispiel eine Kondensfalle umfassen oder als solche ausgebildet sein. Typische Lösemittel kondensieren von selbst aus, ist erstmal ein erster Tropfen an Lösemittel in der Kondensfalle vorhanden. Das Lösemittel zieht gewissermaßen weiteres Lösemittel an sich.

Bei einer bevorzugten Ausführungsform hierzu ist vorgesehen, dass die Kondensfalle als Kühlfalle ausgebildet ist und dass Mittel zum Zuführen eines Kühlmittels zu der Kühlfalle bereitgestellt sind. Eine Kühlfalle arbeitet mit dem Temperaturunterschied zur warmen Luft und kann dadurch besonders effizient und recht schnell das Lösemittel extrahieren.

Ein besonders gutes Material für eine Kondensfalle, insbesondere Kühlfalle, ist Kupfer. Die Kondensfalle bzw. Kühlfalle kann insbesondere einen Kupferhohlkörper aufweisen, der auf eine Temperatur von z.B. zwischen 5° und 15°, vorzugsweise 10°C, gekühlt werden kann. Typischerweise umfasst die Kühlfalle zumindest ein Rohr (insbesondere zumindest ein Kupferrohr), das von einem Kühlmittel durchströmt wird, und auf dessen Außenwandung sich das Lösemittel niederschlägt. Das Rohr ist von einer Umschließung (als Teil der Kühlfalle) umgeben, aus der das (in der Regel) flüssige Lösemittel über einen Auslass (etwa mit einem Hahn an einem Auslassschlauch) abgelassen werden kann. Anstelle von Kupfer kann auch ein anderes Metall, Glas oder ein geeigneter lösemittelbeständiger Kunststoff verwendet werden, wie auch Kombinationen aller genannten Materialien.

Alternativ oder zusätzlich zu einer Kondensfalle können die Mittel zum Entziehen auch einen Aktivkohlefilter, Diphosphorpentoxid und/oder einen Kieselgel-Filter umfassen. Diese Materialien arbeiten sehr effizient, müssen jedoch mit dem Lösemittel ihrerseits dann auch wieder entsorgt werden.

Gemäß einer bevorzugten Ausführungsform der Erfindung kann vorgesehen sein, dass die Aufnahmen für einen Luftstrom offene Schubladen für je eine Flexodruckplatte umfassen. Die im Mittel getränkten Flexodruckplatten lassen sich nicht einfach frei aufhängen, und die Lösung mit den für den Luftstrom offenen Schubladen ermöglicht es, mehrere Flexodruckplatten zugleich in der Vorrichtung anzuordnen und in einem Zug von dem Lösemittel zu befreien.

Gemäß einer bevorzugten Ausführungsform kann vorgesehen sein, dass die Einrichtung zum Bewegen der aufgeheizten Luft ausgelegt ist, Luft in einem geschlossenen Kreislauf zu führen, und dass die Heizeinrichtung einen Wärmetauscher aufweist, der in einer Luftstromrichtung den Mitteln zum Entziehen folgt. Durch den geschlossenen Kreislauf entweicht mit Sicherheit kein Lösemittel in die Umwelt, und die Druckverhältnisse können optimiert werden. Da es sinnvoll ist, das Lösemittel der Luft zu entziehen, bevor die Luft erwärmt wird, ist der Wärmetauscher eben den Mitteln zum Entziehen im Luftstrom nachgeordnet.

Hierzu ist weiter vorzugsweise vorsehbar, dass die Einrichtung zum Bewegen der aufgeheizten, warmen Luft einen Ventilator aufweist, der zwischen den Mitteln zum Entziehen und dem Wärmetauscher angeordnet ist. Der Ventilator kann besonders gut die Temperaturunterschiede abpuffern und wirkt auch in gewisser Weise als Druckbarriere.

Gemäß einer weiteren Ausführungsform der Erfindung kann vorgesehen sein, dass eine Einrichtung zum Wechseln der Richtung des Luftstroms an der Mehrzahl von Aufnahmen vorbei vorgesehen ist. Durch den Wechsel der Richtung des Luftstroms werden die Flexodruckplatten besonders gleichmäßig von dem Lösemittel befreit, und damit gestaltet sich der gesamte Prozess auch etwas schneller.

Es kann hierbei vorgesehen sein, dass zumindest ein der Heizeinrichtung nachgeordnetes Ventil bereitgestellt ist, welches die aufgeheizte Luft wahlweise in verschiedene Leitungen führt. Dieses Ventil stellt gewissermaßen eine Abzweigung dar, die die Richtung des Luftstroms festlegt.

Die Vorrichtung kann zumindest einen Temperatursensor und eine Steuereinrichtung aufweisen, die einen Wechsel der Richtung des Luftstroms an der Mehrzahl von Aufnahmen vorbei in Abhängigkeit von der mittels des zumindest einen Temperatursensors gemessenen Temperatur vornimmt. Beispielsweise kann das Umschalten vorgesehen werden, wenn die Temperaturdifferenz zwischen einem Lufteinlass und einem Luftauslass, definiert bezüglich der Mehrzahl von Aufnahmen, 2°C unterschreitet.

Alternativ ist es möglich, die Umschaltung innerhalb vorgegebener Zeitintervalle vorzusehen, wie z.B. jeweils wieder nach Ablauf eines festgelegten Wertes von Sekunden, z.B. von zwischen 60 und 120 Sekunden, weiter vorzugsweise zwischen 80 und 100 Sekunden, weiter vorzugsweise 90 Sekunden.

Gemäß einem weiteren Aspekt der Erfindung wird ein Verfahren zum Erwärmen von Flexodruckplatten mittels einer Vorrichtung der oben beschriebenen Art bereitgestellt. Das Verfahren kann insbesondere so ausgestaltet werden, dass die Richtung des Luftstroms umgekehrt wird, und zwar immer dann, wenn entweder:
a) die Temperatur der aus der Mehrzahl von Aufnahmen austretenden Luft kleiner ist als ein vorbestimmter Schwellwert, und/oder
b) wenn die Temperaturdifferenz der von der Mehrzahl von Aufnahmen austretenden Luft einerseits zur in die Mehrzahl von Aufnahmen eintretenden Luft andererseits kleiner ist als ein vorbestimmter Schwellwert.

Durch diese Maßnahmen ist gewährleistet, dass sich in der Vorrichtung kein Gleichgewicht einstellt, das dann zu einem wenig effizienten Austragen von Lösemittel aus den Flexodruckplatten führen würde.

Gemäß einem weiteren Aspekt der Erfindung wird ein Verfahren zum Herstellen von Flexodruckplatten bereitgestellt, mit den Schritten: Bereitstellen von ersten Flexodruckplattenrohlingen, Strukturieren der ersten Flexodruckplattenrohlinge unter Verwendung eines Lösemittels zum Auswaschen, Erwärmen der ersten Flexodruckplattenrohlinge mithilfe der oben genannten Vorrichtung mit der Kondensfalle, und dabei Wiedergewinnen des Lösemittels in der Kondensfalle, Bereitstellen von zweiten Flexodruckplattenrohlingen, Strukturieren der zweiten Flexodruckplattenrohlinge unter Verwendung des wiedergewonnenen Lösemittels zum Auswaschen, und Erwärmen der zweiten Flexodruckplatten.

Das verwendete Lösemittel bzw. ein Lösemittelgemisch richtet sich nach der Art des eingesetzten Flexodruckelements. Die DE 10 2010 031 527 A1 nennt an sich bekannte Lösemittel, die auch im vorliegenden Verfahren eingesetzt werden können: Falls das Flexodruckelement eine wässrig entwickelbare fotopolymerisierbare Schicht aufweist, können Wasser oder überwiegend wässrige Lösemittel eingesetzt werden. Für den Fall organisch entwickelbarer Flexodruckelemente eignen sich insbesondere die bekannten Auswaschmittel für Flexodruckplatten, die üblicherweise aus Gemischen verschiedener organischer Lösemittel bestehen, die auf geeignete Art und Weise zusammenwirken. Beispielsweise können Entwickler aus naphthenischen oder aromatischen Erdölfraktionen im Gemisch mit Alkoholen, beispielsweise Benzylalkohol, Cyclohexanol oder aliphatischen Alkoholen mit 5-10 Kohlenstoffatomen, sowie gegebenenfalls weiteren Komponenten, wie beispielsweise alicyclischen Kohlenwasserstoffen, Terpen-Kohlenwasserstoffen, substituierten Benzolen, beispielsweise Diisopropylbenzol, Estern mit 5-12 Kohlenstoffatomen oder Glycolethern eingesetzt werden.

Der Aspekt der Erfindung, dass die Mittel zum Entziehen eine Kondensfalle, insbesondere Kühlfalle, insbesondere Kondensfalle aus Kupfer, aufweisen, ist in besonders sinnvoller Weise umsetzbar, wenn die Vorrichtung die Luft in einem geschlossenen Kreislauf führt.

Der Aspekt, dass die Mittel zum Entziehen einen Aktivkohlefilter, Diphosphorpentoxid und/oder einen Kieselgel-Filter umfassen, ist ein Aspekt, der völlig gesondert von dem Vorsehen einer Kondensfalle umgesetzt werden kann und nicht regelmäßig einen geschlossenen Kreislauf für die Luft verlangt - da beispielsweise der Aktivkohlefilter der Luft das Lösemittel entzieht, ohne sie abzukühlen, kann die von dem Lösemittel befreite Luft auch in die Umwelt abgegeben werden.

### Kurze Beschreibung der Zeichnung

Nachfolgend wird ein Ausführungsbeispiel der Erfindung unter Bezug auf die Zeichnung näher beschrieben, in der
- Fig. 1: den Aufbau einer Vorrichtung gemäß dem Ausführungsbeispiel der Erfindung zeigt, bei einer ersten Luftstromrichtung,

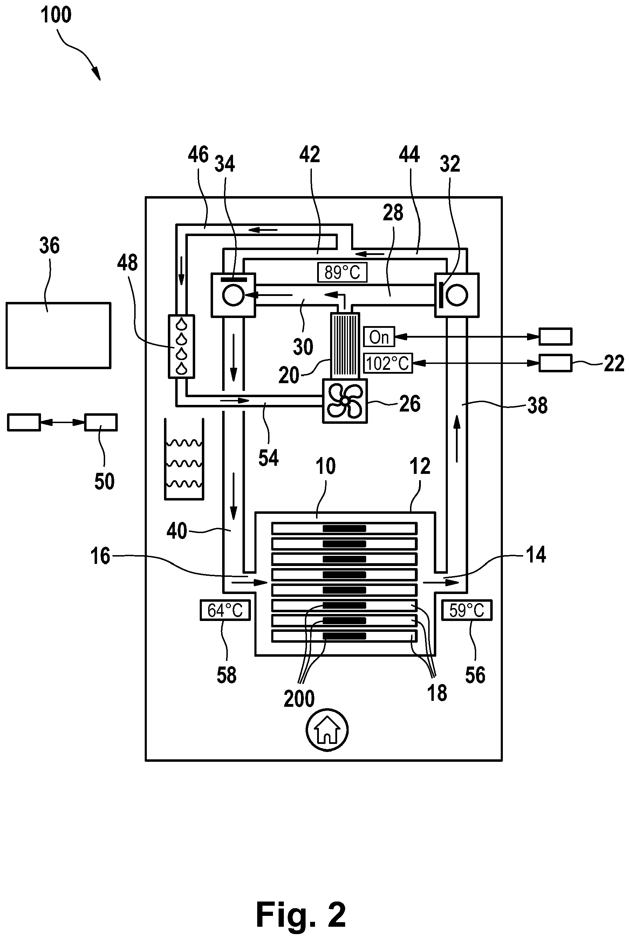

- Fig. 2 und Fig. 3: den Aufbau der Vorrichtung aus Figur 1 zeigt, bei einer zweiten Luftstromrichtung, die Schritte eines Verfahrens zum Herstellen von Flexodruckplatten zeigt.

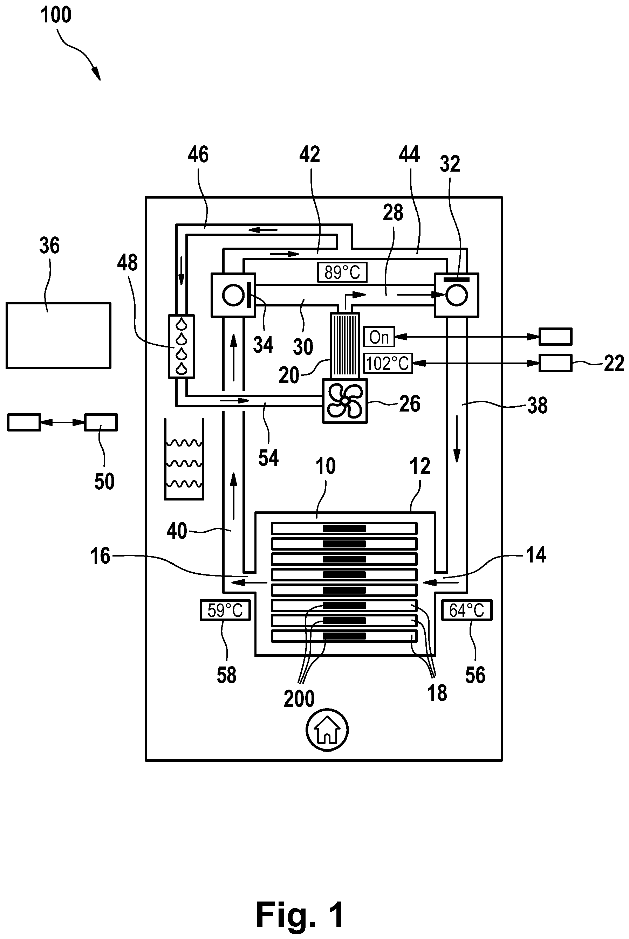

Die in Figur 1 gezeigte und dort im Ganzen mit 100 bezeichnete Vorrichtung zum Befreien von lösemittelhaltigen Flexodruckplatten von dem Lösemittel ist in der Situation dargestellt, in der die Flexodruckplatten 200 bereits in die Vorrichtung aufgenommen sind. Für die Flexodruckplatten 200 gibt es einen Aufnahmeraum 10 in der Vorrichtung 100, abgegrenzt durch dichte Wandungen 12 (etwa aus Stahlblech) und mit einem Einlass 14 und einem Auslass 16 für Luft. Der Einlass 14 kann bei einer Luftstromumkehr als Auslass dienen und der Auslass 16 dann als Einlass.

In dem Aufnahmeraum 10 ist eine Mehrzahl von Aufnahmen 18 für je eine Flexodruckplatte 200 vorgesehen, wobei jede dieser Aufnahmen als Schublade ausgebildet sein kann. Die Schubladen können auch alternativ mehr als eine Flexodruckplatte aufnehmen. Auf diese Weise lässt sich der Aufnahmeraum 10 sehr schnell mit den Flexodruckplatten 200 befüllen. Die Schubladen sind durch geeignete Dichtungen, z.B. Gummidichtungen oder mit Plüsch, versiegelt.

Die Vorrichtung 100 arbeitet mit warmer Luft, um das Lösemittel den Flexodruckplatten zu entziehen. Daher ist als Wärmequelle, als Heizeinrichtung zum Heizen von Luft, also Einrichtung zum Bereitstellen von aufgeheizter Luft, ein Wärmetauscher 20 vorgesehen, wobei dieser an einer Eingangsseite 22 mit entsprechendem heißen Fluid beaufschlagt wird, das extern bereitgestellt wird.

Dem Wärmetauscher 20 im Luftstrom vorgeordnet kann ein Ventilator 26 als Teil der Einrichtung zum Bewegen der warmen, aufgeheizten Luft vorgesehen sein. Der Ventilator 26 drückt die Luft durch den Wärmetauscher 20 wahlweise in einen Leitungszweig 28 oder in einen Leitungszweig 30. Im Falle der Figur 1 wird die Luft durch den Leitungszweig 28 gedrückt, weil an einem Ventil 32 eine Klappe so eingestellt ist, dass der Luftstrom weiterlaufen kann. Hingegen ist hinsichtlich des zweiten Leitungszweiges 30 eine Klappe an einem Ventil 34 so gestellt, dass der Luftstrom blockiert ist.

Die Klappen der Ventile 32 und 34 werden durch eine Steuereinrichtung 36 angesteuert. Im Falle der Figur 1 also strömt die Luft durch eine Leitung 38 (etwa in Form eines geschlossenen Rohrs aus Stahl, Aluminium oder Kupfer) zum Einlass 14. Hinter dem Wärmetauscher weist die Luft eine Temperatur von ca. 89°C auf, dies hat sich bis zum Einlass 14 typischerweise auf 64°C verringert.

Die über den Einlass 14 eintretende Luft löst aus den Flexodruckplatten 200 das Lösemittel, wobei sich die Luft abkühlt: Am Auslass 16 weist die Luft eine Temperatur von z.B. 59°C auf. Es geht der Luftstrom durch die Leitung 40 weiter an dem Ventil 34 vorbei, wo die Klappe nun so steht, dass die Luft in einen Leitungszweig 42 eintreten kann, von dort in einen Leitungszweig 46 und von dort in eine Kühlfalle 48, die als Kondensfalle für das in der Luft nunmehr enthaltene Lösemittel dient.

Die Kühlfalle 48 wird mithilfe eines über einen Einlass 50 zugeführten Kühlmittels (z.B. einfach kaltem Wasser) gekühlt. Sie kann insbesondere eine (insbesondere thermisch isolierte) Umschließung mit einem darin befindlichen Kupferhohlkörper aufweisen. Das kondensierte Lösemittel kann über einen (in der Figur nicht gezeigten) Auslasshahn an der Umschließung entnommen werden. Hinter der Kühlfalle 48 strömt die Luft nunmehr in den Leitungszweig 54 zum Ventilator 26, wo der Kreislauf erneut beginnt.

Im Bereich des Einlasses 14 ist ein Temperatursensor 56 vorgesehen, im Bereich des Auslasses 16 ein Temperatursensor 58. Im Sollzustand besteht die Temperaturdifferenz zwischen 64°C und 59°C, also ca. 5°C. Die Temperatursensoren 56 und 58 senden entsprechende Messsignale an die Steuereinrichtung 36. Nach einer Zeit des Betriebs sinkt die Temperaturdifferenz nun, beispielsweise auf zwischen 62°C und 60°C.

Zur Förderung einer schnellen Trocknung wird nun die Richtung des Luftstroms umgekehrt, siehe Fig, 2: Dazu werden die Ventilklappen an den Ventilen 32 und 34 nunmehr umgestellt, so dass die Luft von dem Wärmetauscher 20 in den Leitungszweig 30 läuft und von diesem in den Leitungszweig 40 zum bisherigen Auslass 16 hin, der jetzt als Einlass fungiert. Die Luft strömt aus dem bisherigen Einlass 14, der jetzt als Auslass fungiert, in die Leitung 38 und aufgrund der Stellung der Klappe am Ventil 32 erst in den Leitungszweig 44, dann in den Leitungszweig 46 und wieder zur Kühlfalle 48.

Die Steuereinrichtung 36 kann auch ein komplexeres Verfahren durchlaufen, beispielsweise auch eine Zeitkomponente einführen: Unterscheidet die Temperaturdifferenz nach einer vorbestimmten Höchstzeit nicht den Schwellwert von beispielsweise 2°C, dann kann ergänzend vorgesehen sein, dass aufgrund Zeitablaufs die Umschaltung in der Strömungsrichtung der Luft erfolgt. Auch das Verwenden von komplexeren Funktionen, beispielsweise einer Funktion b( ΔT, T1, T2, t) kann vorgesehen sein, wobei die Funktion b angibt, ob eine Umschaltung in der Strömungsrichtung erfolgt (etwa als binäre Funktion b, b=1: erste Strömungsrichtung, b=0: zweite Strömungsrichtung), und wobei T1 und T2 die Temperaturen sind, die die Sensoren 56 bzw. 58 messen, ΔT die Differenz |T2-T1| ist, und wobei t die Zeit seit der letzten Richtungsumschaltung ist.

Mittels der Vorrichtung 100 ist es möglich, aus der Kühlfalle das Lösemittel zu entnehmen und wiederzuverwenden. Hier muss gegebenenfalls noch eine gewisse Menge an Alkohol zugesetzt werden. Die Menge an Alkohol kann aufgrund einer Messung der Menge des Lösemittels und/oder seiner Dichte oder dergleichen festgelegt werden.

Die vorliegende Beschreibung bezieht sich auf den Aspekt, dass die Mittel zum Entziehen des Lösemittels eine Kondensfalle in Form einer Kühlfalle mit einem Kupferhohlkörper aufweisen. Die Vorrichtung lässt sich so abwandeln, dass an der Stelle der Kühlfalle 48 ein Aktivkohlefilter oder ein Filter aus Diphosphorpentoxid bzw. ein Kieselgel-Filter vorgesehen wird. Abweichend von dem bisher Beschriebenen kann bei Verwendung solcher Filter auf einen geschlossenen Luftkreislauf verzichtet werden, der bei der Kühlfalle zu bevorzugen ist.

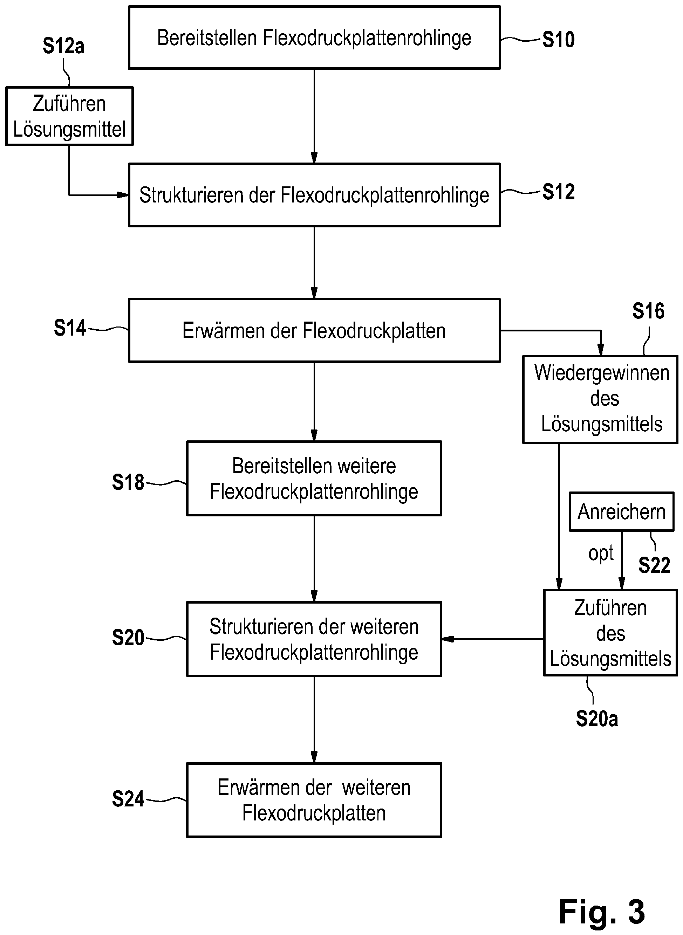

Durch die Vorrichtung 100 wird ein Verfahren zum Herstellen von Flexodruckplatten gemäß Figur 3 ermöglicht. Im Prinzip wird das Verfahren durchgeführt wie in der EP 1 033 622 B1 beschrieben.

In Schritt S10 werden zunächst Flexodruckplattenrohlinge bereitgestellt, die dann in Schritt S12 strukturiert werden, etwa durch Ultraviolettstrahlung. Ein Aspekt des Strukturierens besteht in dem Auswaschen der nicht strukturierten Teile, wozu in Schritt S12a Lösemittel zugeführt wird. Das Lösemittel wird in Schritt S14 mittels der Vorrichtung 100 entfernt, wozu die Flexodruckplatten 200 nach dem Strukturieren in die Schubladen 18 verbracht werden. Gemäß Schritt S16 wird in der Kühlfalle 48 das Lösemittel wiedergewonnen. Nun können weitere Flexodruckplattenrohlinge in Schritt S18 bereitgestellt werden und in Schritt S20 strukturiert werden, wobei das diesmal in Schritt S20a zugeführte Lösemittel das wiedergewonnene Lösemittel ist, welches optional in Schritt S22 mit Alkohol oder einem sonstigen Mittel angereichert wird. Nach dem Strukturieren in Schritt S20 erfolgt wiederum ein Erwärmen der weiteren Flexodruckplatten in Schritt S24 zum erneuten Entfernen des Lösemittels.

Das Verfahren ist umweltfreundlich, weil das Lösemittel nicht in die Umwelt abgegeben wird, sondern rückgewonnen wird. Das ist außerdem auch effizient und ökonomisch, weil das rückgewonnene Lösemittel auch erneut verwendet wird.

**Bezugszeichenliste**

| | |
|---|---|
| 10 | Aufnahmeraum |
| 12 | Wandungen |
| 14 | Einlass |
| 16 | Auslass |
| 18 | Schublade |
| 20 | Wärmetauscher |
| 22 | Eingangsseite |
| 26 | Ventilator |
| 28 | Leitungszweig |
| 30 | Leitungszweig |
| 32 | Ventil |
| 34 | Ventil |
| 36 | Steuereinrichtung |
| 38 | Leitung |
| 40 | Leitung |
| 42 | Leitungszweig |
| 44 | Leitungszweig |
| 46 | Leitungszweig |
| 48 | Kühlfalle |
| 50 | Einlass |
| 54 | Leitungszweig |
| 56 | Temperatursensor |
| 58 | Temperatursensor |
| 100 | Vorrichtung |
| 200 | Flexodruckplatte |
| | |
| S10, S12, S12a, S14, S16, S18, S20, S20a, S22, S24 | Schritte eines Verfahrens |

## Patentansprüche

1. Vorrichtung (100) zum Befreien von lösemittelhaltigen Flexodruckplatten (200) von dem Lösemittel,
mit einer Mehrzahl von Aufnahmen (18) für je zumindest eine Flexodruckplatte (200),
mit einer Heizeinrichtung (20) zum Heizen von Luft,
mit einer Einrichtung (26, 28, 30, 38, 40, 42. 44. 46, 54) zum Bewegen der aufgeheizten Luft an in der Mehrzahl von Aufnahmen (18) aufgenommenen Flexodruckplatten (200) vorbei, sodass die aufgeheizte Luft Lösemittel von den Flexodruckplatten (200) aufnimmt, und einer Einrichtung (32, 34, 36) zum Wechseln der Richtung des Luftstroms an der Mehrzahl von Aufnahmen vorbei, und
mit Mitteln (48) zum Entziehen, um das Lösemittel der Luft wieder zu entziehen.

2. Vorrichtung (100) nach Anspruch 1, **dadurch gekennzeichnet, dass** die Mittel zum Entziehen eine Kondensfalle (48) umfassen.

3. Vorrichtung (100) nach Anspruch 2, **dadurch gekennzeichnet, dass** die Kondensfalle als Kühlfalle (48) ausgebildet ist und dass Mittel (52) zum Zuführen eines Kühlmittels zu der Kühlfalle bereitgestellt sind.

4. Vorrichtung (100) nach Anspruch 2 oder 3, **dadurch gekennzeichnet, dass** die Kondensfalle (48) Kupfer aufweist.

5. Vorrichtung nach einem der vorhergehenden Ansprüche, **dadurch gekennzeichnet, dass** die Mittel zum Entziehen einen Aktivkohlefilter, Diphosphorpentoxid und/oder einen Kieselgel-Filter umfassen.

6. Vorrichtung (100) nach einem der vorhergehenden Ansprüche, **dadurch gekennzeichnet, dass** die Aufnahmen für einen Luftstrom offene Schubladen (18) für je eine Flexodruckplatte (200) umfassen.

7. Vorrichtung (100) nach einem der vorhergehenden Ansprüche, **dadurch gekennzeichnet, dass** die Einrichtung zum Bewegen der aufgeheizten Luft ausgelegt ist, Luft in einem geschlossenen Kreislauf (26, 28, 30, 38, 40, 42. 44. 46, 54) zu führen, und dass die Heizeinrichtung einen Wärmetauscher (20) aufweist, der in einer Luftstromrichtung den Mitteln (48) zum Entziehen folgt.

8. Vorrichtung (100) nach Anspruch 7, **dadurch gekennzeichnet, dass** die Einrichtung zum Bewegen der aufgeheizten Luft einen Ventilator (26) umfasst, der zwischen den Mitteln zum Entziehen und dem Wärmetauscher angeordnet ist.

9. Vorrichtung (100) nach einem der vorhergehenden Ansprüche, **gekennzeichnet durch** zumindest ein der Heizeinrichtung (20) nachgeordnetes Ventil (32, 34), das die aufgeheizte Luft wahlweise in verschiedene Leitungen führt.

10. Vorrichtung (100) nach einem der vorhergehenden Ansprüche, mit zumindest einem Temperatursensor (56, 58) und einer Steuereinrichtung (36), die einen Wechsel der Richtung des Luftstroms an der Mehrzahl von Aufnahmen (18) vorbei in Abhängigkeit von der mittels des zumindest einen Temperatursensors (56, 58) gemessenen Temperatur vornimmt.

11. Verfahren zum Erwärmen von Flexodruckplatten (200) mittels einer Vorrichtung (100) nach einem der vorhergehenden Ansprüche.

12. Verfahren nach Anspruch 11 zum Erwärmen von Flexodruckplatten (200), **dadurch gekennzeichnet, dass** die Richtung des Luftstroms immer dann umgekehrt wird, wenn die Temperatur der aus der Mehrzahl von Aufnahmen (18) austretenden Luft kleiner ist als ein vorbestimmter Schwellwert.

13. Verfahren zum Herstellen von Flexodruckplatten, mit den Schritten:
Bereitstellen von ersten Flexodruckplattenrohlingen,
Strukturieren der ersten Flexodruckplattenrohlinge unter Verwendung eines Lösemittels,
Erwärmen der ersten Flexodruckplattenrohlinge mithilfe einer Vorrichtung mit den Merkmalen gemäß Anspruch 2, 3 oder 4, und dabei Wiedergewinnen des Lösemittels in der Kondensfalle,
Bereitstellen von zweiten Flexodruckplattenrohlingen,
Strukturieren der zweiten Flexodruckplattenrohlinge unter Verwendung des wiedergewonnenen Lösemittels, und
Erwärmen der zweiten Flexodruckplatten.

14. Verfahren nach Anspruch 13, bei dem als Lösemittel eines aus
- Wasser,
- einem wässrigen Lösemittel, oder
- einem Gemisch aus einerseits einem Entwickler aus naphthenischen oder aromatischen Erdölfraktionen und anderseits Alkoholen, beispielsweise Benzylalkohol, Cyclohexanol oder aliphatischen Alkoholen mit 5-10 Kohlenstoffatomen, sowie optional einer weiteren Komponente, wie beispielsweise alicyclischen Kohlenwasserstoffen, Terpen-Kohlenwasserstoffen, substituierten Benzolen, Estern mit 5 bis 12 Kohlenstoffatomen oder Glycolether verwendet wird.

## Claims

1. A device (100) for removing the solvent from solvent-containing flexographic printing plates (200),
comprising a plurality of receptacles (18) for at least one flexographic printing plate (200) in each case;
comprising a heating unit (20) for heating air;
comprising a unit (26, 28, 30, 38, 40, 42, 44, 46, 54) for moving the heated air past flexographic printing plates (200) accommodated in the plurality of receptacles (18) so that the heated air picks up solvent from the flexographic printing plates (200), and a unit (32, 34, 36) for changing the direction of the air flow past the plurality of receptacles; and
comprising means (48) for withdrawing so as to withdraw the solvent from the air again.

2. The device (100) according to claim 1, **characterized in that** the means for withdrawing comprise a condensate trap (48).

3. The device (100) according to claim 2, **characterized in that** the condensate trap is designed as a cold trap (48), and that means (52) for supplying a coolant to the cold trap are provided.

4. The device (100) according to claim 2 or 3, **characterized in that** the condensate trap (48) comprises copper.

5. The device according to any one of the preceding claims, **characterized in that** the means for withdrawing comprise an activated carbon filter, diphosphorus pentoxide and/or a silica gel filter.

6. The device (100) according to any one of the preceding claims, **characterized in that** the receptacles comprise drawers (18) for a respective flexographic printing plate (200) which are open to an air flow.

7. The device (100) according to any one of the preceding claims, **characterized in that** the unit for moving the heated air is configured to guide air in a closed circuit (26, 28, 30, 38, 40, 42, 44, 46, 54), and that the heating unit comprises a heat exchanger (20), which is situated downstream from the means (48) for withdrawing in an air flow direction.

8. The device (100) according to claim 7, **characterized in that** the unit for moving the heated air comprises a fan (26), which is arranged between the means for withdrawing and the heat exchanger.

9. The device (100) according to any one of the preceding claims, **characterized by** at least one valve (32, 34), which is arranged downstream from the heating unit (20) and selectively guides the heated air into different lines.

10. The device (100) according to any one of the preceding claims, comprising at least one temperature sensor (56, 58) and a control unit (36), which implements a change in the direction of the air flow past the plurality of receptacles (18), as a function of the temperature measured by means of the at least one temperature sensor (56, 58).

11. A method for heating flexographic printing plates (200) by means of a device (100) according to any one of the preceding claims.

12. The method according to claim 11 for heating flexographic printing plates (200), **characterized in that** the direction of the air flow is reversed whenever the temperature of the air exiting the plurality of receptacles (18) is lower than a predetermined threshold value.

13. A method for producing flexographic printing plates, comprising the following steps:
providing first flexographic printing plate blanks;
structuring the first flexographic printing plate blanks, using a solvent;
heating the first flexographic printing plate blanks with the aid of a device having the features according to claim 2, 3 or 4, while recovering the solvent in the condensate trap;
providing second flexographic printing plate blanks;
structuring the second flexographic printing plate blanks, using the recovered solvent; and
heating the second flexographic printing plates.

14. The method according to claim 13, wherein the solvent used is one of
- water;
- an aqueous solvent; or
- a mixture of developers made of naphthenic or aromatic petroleum fractions on the one hand, and alcohols on the other hand, for example benzyl alcohol, cyclohexanol or aliphatic alcohols having 5 to 10 carbon atoms, as well as optionally a further component, such as, for example, alicyclic hydrocarbons, terpene hydrocarbons, substituted benzenes, esters having 5 to 12 carbon atoms, or glycol ethers.

## Revendications

1. Dispositif (100) d'enlèvement de solvant de plaques d'impression flexographique (200) contenant du solvant,
avec une multiplicité de réceptacles (18) pour au moins une plaque d'impression flexographique (200),
avec un dispositif de chauffage (20) pour le chauffage d'air,
avec un dispositif (26, 28, 30, 38, 40, 42, 44,46, 54) pour déplacer l'air réchauffé sur les plaques d'impression flexographique (200) logées dans la multiplicité des réceptacles (18) de sorte que l'air réchauffé absorbe des solvants à partir des plaques d'impression flexographique (200), et un dispositif (32, 34, 36) pour changer la direction du courant d'air sur la multiplicité des réceptacles, et
avec des moyens (48) de séparation afin de retirer de nouveau le solvant à partir de l'air.

2. Dispositif (100) selon la revendication 1, **caractérisé en ce que** les moyens de séparation comprennent un piège de condensation (48).

3. Dispositif (100) selon la revendication 2, **caractérisé en ce que** le piège de condensation est conçu comme un piège à refroidissement (48) et que des moyens (52) permettant l'alimentation en produit de refroidissement sont fournis avec le piège à refroidissement.

4. Dispositif (100) selon la revendication 2 ou la revendication 3, **caractérisé en ce que** le piège de condensation (48) présente du cuivre.

5. Dispositif selon l'une des revendications précédentes, **caractérisé en ce que** les moyens de séparation comprennent un filtre à charbon actif, du di phosphore pentoxyde et/ou un filtre à gravier.

6. Dispositif (100) selon l'une des revendications précédentes, **caractérisé en ce que** les réceptacles comprennent des tiroirs (18) ouverts à un courant d'air pour chaque plaque d'impression flexographique (200).

7. Dispositif (100) selon l'une des revendications précédentes, **caractérisé en ce que** le dispositif est conçu pour le déplacement de l'air réchauffé, pour alimenter l'air dans un cycle fermé (26, 28, 30, 38, 40, 42, 44, 46, 54) et que le dispositif de chauffage présente un échangeur de chaleur (20) qui suit un des moyens de séparation (48) dans la direction du courant d'air.

8. Dispositif (100) selon la revendication 7, **caractérisé en ce que** le dispositif de déplacement de l'air réchauffé comprend un ventilateur (26) qui est disposé entre les moyens de séparation et l'échangeur de chaleur.

9. Dispositif (100) selon l'une des revendications précédentes, **caractérisé par** au moins une soupape (32, 34) disposée après le dispositif de chauffage (20) qui emmène l'air réchauffé sélectivement dans diverses conduites.

10. Dispositif (100) selon l'une des revendications précédentes, avec au moins un capteur de température (56, 58) et un dispositif de commande (36), qui détecte une variation de la direction du courant d'air sur la multiplicité de réceptacles (18) en fonction de la température mesurée au moyen de l'au moins un capteur de température (56, 58).

11. Procédé de chauffage de plaques d'impression flexographique (200) au moyen d'un dispositif (100) selon l'une des revendications précédentes.

12. Procédé selon la revendication 11 pour le réchauffage de plaques d'impression flexographique (200), **caractérisé en ce que** la direction du courant d'air est toujours inversée lorsque la température de l'air sortant de la multiplicité des réceptacles (18) est inférieure à une valeur de seuil prédéfinie.

13. Procédé de fabrication de plaques d'impression flexographique avec les étapes :
de fourniture de premières ébauches de plaques d'impression flexographique,
de structuration des premières ébauches de plaques d'impression flexographique moyennant l'emploi d'un solvant,
de chauffage des premières ébauches de plaques d'impression flexographique à l'aide d'un dispositif avec les propriétés selon la revendication 2, 3 ou 4 et ce faisant le recyclage du solvant dans le piège de condensation ,
de fourniture de deuxièmes ébauches de plaques d'impression flexographique,
de structuration des deuxièmes ébauches de plaques d'impression flexographique moyennant l'emploi du solvant récupéré, et
de chauffage des deuxièmes ébauches de plaques d'impression flexographique.

14. Procédé selon la revendication 13, chez lequel on emploie en tant que solvant un solvant à base
- d'eau,
- d'un solvant aqueux, ou
- d'un mélange à base d'une part d'un révélateur à base de fractions de pétrole brut naphténiques ou aromatiques, et d'autre part d'alcools, par exemple, d'alcool benzylique, de cyclohexanol ou d'alcools aliphatiques avec 5 à 10 atomes de carbone, ainsi qu'éventuellement un autre composant comme, par exemple, des carbohydrates alicycliques, des carbohydrates terpéniques, des benzols substitué, des esters avec 5 à 12 atomes de carbone ou du glycol éther.
